# EUROPÄISCHE PATENTANMELDUNG

(11) **EP 1 801 967 A2**
(43) Veröffentlichungstag der Anmeldung: **27.06.2007**
(21) Anmeldenummer: 06125920.6
(22) Anmeldetag: 12.12.2006
(51) Int. Cl.: H03G 7/00, H04B 3/54, H04B 10/207, H01S 3/067, H04J 14/02, H04L 12/28

(54) **Aktiver Sternpunkt für den Einsatz in einem Kommunikationssystem mit Sterntopologie**

(30) Priorität: 22.12.2005 DE 102005061395
(71) Anmelder: ROBERT BOSCH GMBH, 70442 Stuttgart (DE)
(72) Erfinder: Schirmer, Juergen, 69124, Heidelberg (DE); Dostert, Klaus, 67706, Krickenbach (DE); Huck, Thorsten, 76477, Elchesheim-Illingen (DE)

(57) **Zusammenfassung**

Die vorliegenden Erfindung betrifft einen aktiven Sternkoppler (1; 30) für den Einsatz in einem Kommunikationssystem mit Sterntopologie, wobei der Sternkoppler (1; 30) mindestens einen Eingang (2; 31) für ein eingehendes analoges Datensignal (40) und mindestens einen Ausgang (3, 4; 32, 33) für ein abgehendes analoges Datensignal (41) und zwischen dem mindestens einen Eingang (2; 31) und dem mindestens einen Ausgang (3, 4; 32, 33) angeordnete Mittel (5, 6, 7; 34, ..., 39) zum Verstärken des eingehenden Datensignals (40) aufweist. Um einen möglichst einfach und kostengünstig aufgebauten Sternkoppler (1; 30) vorzuschlagen, der jedoch geforderte Protokollspezifikationen eines Kommunikationssystems, insbesondere eine FlexRay-Protokollspezifikation und eine Powerline Communications (PLC)-Protokollspezifikation, erfüllt, wird vorgeschlagen, dass die Verstärkermittel (5, 6, 7; 34,..., 39) als analoge Signalverstärkermittel zur unmittelbaren Verstärkung eines in den Sternkoppler (1; 30) eingehenden analogen Datensignals (40) ausgebildet sind. Vorzugsweise sind die analogen Signalverstärkermittel als Automatic Gain Control (AGC)-Schleifen (5, 6, 7; 34, ..., 39) mit einem Variable Gain Amplifier (VGA) (8, 9, 10) und einem Root-Mean-Sqaure (RMS)-Detektor (11, 12, 13) ausgebildet.

## Beschreibung

### Stand der Technik

Die vorliegende Erfindung betrifft einen aktiven Sternkoppler für den Einsatz in einem Kommunikationssystem mit Sterntopologie. Der Sternkoppler weist mindestens einen Eingang für ein eingehendes analoges Datensignal und mindestens einen Ausgang für ein abgehendes analoges Datensignal und zwischen dem mindestens einen Eingang und dem mindestens einen Ausgang angeordnete Mittel zum Verstärken des eingehenden Datensignals auf.

Derartige Sternkoppler sind beispielsweise für FlexRay-Kommunikationssysteme aus der FlexRay-Spefizikation v2.1 bekannt. Der Aufbau und die Funktionsweise gehören zu der spezifizierten physikalischen Schicht (sogenannter Physical Layer) des FlexRay-Kommunikationssystems. Aktive Sternkoppler sind in Kommunikationsnetzen von Bedeutung, in denen sich die Kommunikationsverbindung (zum Beispiel ein Datenbus) aufspaltet, also eine Sterntopologie hat, und ein Datensignal auf mehrere Zweige des Datenbusses aufgeteilt werden soll. Außerdem sind aktive Sternkoppler von Bedeutung, wenn es um die Übertragung von Datensignalen über komplexe Netztopologien und längere Strecken geht, da sie zusätzlich oder alternativ zur Aufteilung des Datensignals auf mehrere Zweige das Signal auch verstärken können.

Ein entsprechender aktiver Sternkoppler (sogenannter Active Star) für den Einsatz in einem FIexRay-Kommunikationssystem wird unter der Bezeichnung "SJA 2510" von der Firma Philips Semiconductors angeboten. In dem angebotenen Sternkoppler sind FlexRay-Kommunikations-Controller gemäß der Spezifikation v2.1 und ein ARM9-Mikrocontroller integriert. An dem bekannten aktiven Sternkoppler sind mehrere Anschlüsse vorgesehen, an die mehrere Zweige der Kommunikationsverbindung angeschlossen sind. Die Anschlüsse können entweder als Eingang für eingehende Datensignale und/oder als Ausgang für ausgehende Datensignale konfiguriert werden. Der Sternkoppler weist an jedem Anschluss einen Bus-Treiber zum Verstärken eines ausgehenden Datensignals auf. Ein über einen der Anschlüsse eingehendes analoges Datensignal wird an eine zentrale Verarbeitungslogik des Sternkopplers weitergeleitet, die ein Rechengerät, bspw. in Form eines Field Programmable Gate Arrays (FPGA), eines Mikrocontrollers oder eines digitalen Signalprozessors (DSP), aufweist.

Die zentrale Verarbeitungslogik digitalisiert das eingehende analoge Datensignal und ermöglicht so eine Weiterverarbeitung des Datensignals (z.B. Überwachungs- und/oder Routerfunktion) in dem aktiven Sternkoppler. Falls in dem Sternkoppler ein Kommunikations-Controller vorgesehen ist, kann dieser in Abhängigkeit von dem Inhalt des in der zentralen Verarbeitungslogik dekodierten eingehenden Datensignals eine Überwachungs- und/oder Routerfunktion übernehmen. Ein ebenfalls optional vorgesehener Bus-Guardian kann den Zugriff des Kommunikations-Controllers des Sternkopplers auf den Datenbus überwachen und/oder steuern. Das in der zentralen Verarbeitungslogik vorhandene eingegangene digitale Datensignal wird über Bus-Treiber (sogenannter Bus Driver), welche die Bitfolge des digitalen Signals in eines oder mehrere analoge Signale zurückwandeln und verstärken, an die Kommunikationsverbindung angelegt.

Die aus dem Stand der Technik von Philips bekannten aktiven Sternkoppler umfassen Bustreiber vom Typ Philips "TJA 1080", die denen von FlexRay-Transceivereinheiten entsprechen. Der bekannte Sternkoppler ist somit nichts anderes als eine Verknüpfung mehrerer Transceiver zu einem Hub. Ein Hub leitet von einem Teilnehmer eines Kommunikationsnetzwerks über einen Zweig der Kommunikationsverbindung eingehende Daten an alle übrigen Teilnehmer des Kommunikationssystems weiter und verstärkt gleichzeitig das weiter zu leitende Signal. Ein Hub beinhaltet jedoch weitaus mehr Funktionen als für einen aktiven Sternkoppler eigentlich erforderlich wären.

Funktionen, die für einen Sternkoppler eigentlich nicht erforderlich wären, sind beispielsweise die Umwandlung eines eingehenden analogen Datensignals in ein binäres Signal, eine Verarbeitung des binären Signals zur Realisierung einer Überwachungs- und/oder Routerfunktion, sowie die Realisierung einer Transceiver-Funktion der Bus-Treiber an den Anschlüssen des bekannten aktiven Sternkopplers.

Ausgehend von dem genannten Stand der Technik liegt der vorliegenden Erfindung die Aufgabe zugrunde, einen aktiven Sternkoppler bereitzustellen, der insbesondere für den Einsatz in einem Kraftfahrzeug ausgelegt sein soll. Das bedeutet, er muss robust arbeiten, kleinbauend und leicht ausgebildet, und kostengünstig realisierbar sein. Gleichzeitig muss der aktive Sternkoppler der Spezifikation und den Anforderungen an ein modernes Kommunikationssystem gerecht werden.

### Offenbarung der Erfindung

Zur Lösung dieser Aufgabe, wird ausgehend von dem aktiven Sternkoppler der eingangs genannten Art vorgeschlagen, dass die Verstärkermittel als analoge Signalverstärkermittel zur unmittelbaren Verstärkung eines in den Sternkoppler eingehenden analogen Datensignals ausgebildet sind.

Bevorzugte Ausführungsformen der Erfindung können den Unteransprüchen entnommen werden. Weitere Merkmale und Vorteile der Erfindung können einzeln oder in Kombination der nachfolgenden Beschreibung, insbesondere unter Bezugnahme auf die beiliegenden Figuren, entnommen werden.

### Vorteile der Erfindung

Anders als bei den aus dem Stand der Technik bekannten aktiven Sternkopplern wird bei dem erfindungsgemäßen Sternkoppler nicht ein digitales Signal, sondern unmittelbar das eingehende analoge Datensignal verstärkt, ohne dass es zuvor digitalisiert werden müsste. Durch den Einsatz der analogen Signalverstärkermittel können somit Bauteile, Bauraum, Gewicht und Kosten eingespart werden. Ein ganz besonderer Vorteil des Verzichts auf die D/A-Wandlung des eingehenden Datensignals vor und nach der Verstärkung liegt in der deutlich schnelleren Verarbeitung und Weiterleitung des Datensignals in dem erfindungsgemäßen aktiven Sternkoppler.

Hinsichtlich der kritischen Randbedingungen diverser EMV-Richtlinien, wird der Einsatz von variabel angepassten Verstärkerschaltungen im Zusammenhang mit der Realisation aktiver Sternpunkte vorgestellt. Neben dem speziellen Einsatz in einem hochdatenratigen Powerline Communications (PLC)-System stellt dieses Konzept auch eine interessante Perspektive für andere Kommunikationssysteme, beispielsweise für ein FlexRay-Kommunikationssystem, dar.

Mit dem vorgeschlagenen Konzept ist es möglich, einen einfachen, sehr effizienten, bzw. kostengünstigen aktiven Sternkoppler gemäß der jeweiligen Protokollspezifikation des Kommunikationssystems aufzubauen. Gerade im Rahmen der Automobilindustrie sind kosteneffiziente Lösungen für die Bereitstellung von hochdatenratigen Kommunikationssystemen und Kommunikationsverbindungen von großem Vorteil. Im Gegensatz zu herkömmlichen aktiven Sternkopplern, bzw. Hubs ist durch die vorgeschlagene Realisierung eine schnelle Verarbeitung des eingehenden Datensignals möglich, da auf eine Digitalisierung des eingehenden analogen Signals und auf eine Digital-Analog-Wandlung des verstärkten digitalen Signals verzichtet werden kann. Die besonders schnelle Verarbeitung, die durch den erfindungsgemäßen aktiven Sternkoppler möglich wird, wirkt sich positiv auf Transport- und/oder Übertragungsverzögerungen (Propagation Delay) des gesamten Systems aus. Somit können bei den empfangenden Teilnehmern des Kommunikationssystems leistungsstärkere Algorithmen zur Fehlerdetektion bzw. Fehlerkorrektur, insbesondere zur Bitfehlerkorrektur, zur Anwendung kommen, was wiederum zu einer Reduktion der Bitfehlerwahrscheinlichkeit führt.

### Zeichnungen

Nachfolgend werden anhand der Figuren und der dazugehörigen Figurenbeschreibung weitere Merkmale und Vorteile der Erfindung näher erläutert. Es zeigen:
- Figur 1: einen erfindungsgemäßen aktiven Sternkoppler für ein FlexRay-Kommunikationssystem gemäß einer ersten bevorzugten Ausführungsform;
- Figur 2: einen aus dem Stand der Technik bekannten aktiven Sternkoppler für ein FlexRay-Kommunikationssystem;
- Figur 3: den erfindungsgemäßen Sternkoppler aus Figur 1 in einem Idle-Betriebsmodus;
- Figur 4: den aktiven Sternkoppler aus Figur 1 in einem Verstärker-Betriebsmodus;
- Figur 5: einen erfindungsgemäßen aktiven Sternkoppler gemäß einer weiteren bevorzugten Ausführungsform in schematischer Ansicht; und
- Figur 6: eine andere Ansicht des erfindungsgemäßen Sternkopplers aus Figur 5.

### Beschreibung der Ausführungsbeispiele

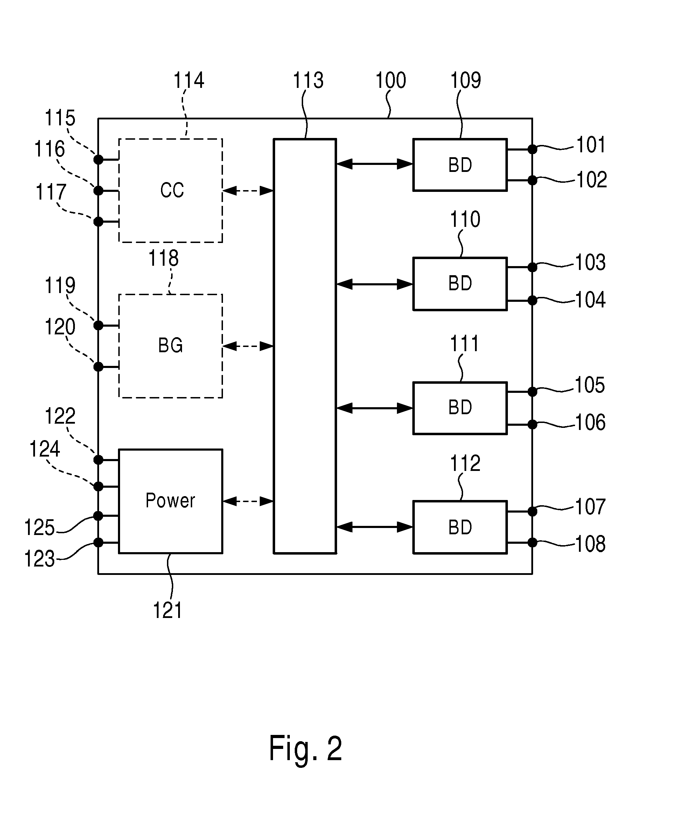

In Figur 2 ist ein aus dem Stand der Technik bekannter aktiver Sternkoppler für ein FlexRay-Kommunikationssystem in seiner Gesamtheit mit dem Bezugszeichen 100 bezeichnet. Der Sternkoppler 100 wird in der FlexRay-Protokollspezifikation auch als aktiver Sternpunkt (Active Star) bezeichnet. Der in Figur 2 dargestellte Sternkoppler 100 kann an bis zu vier Zweige einer Kommunikationsverbindung (z.B. eines Datenbusses) angeschlossen werden. Die Kommunikationsverbindung kann eine oder mehrere elektrische Leitungen, eine oder mehrere optische Leitungen oder andersartig ausgebildete Übertragungskanäle, beispielsweise Funkverbindungen, aufweisen. Der in Figur 2 dargestellte Sternkoppler 100 ist über einen ersten Anschluss 101 und einen zweiten Anschluss 102 jeweils an eine Leitung eines ersten Zweiges der Kommunikationsverbindung (nicht dargestellt) angeschlossen. Über weitere Anschlüsse 103, 104; 105, 106 und 107, 108 ist der aktive Sternkoppler 100 in entsprechender Weise an jeweils zwei Leitungen von weiteren Zweigen der Kommunikationsverbindung angeschlossen. Der Sternkoppler 100 könnte also in einem FlexRay-Kommunikationssystem mit einer Kommunikationsverbindung mit Sterntopologie und bis zu vier Zweigen (oder Armen) eingesetzt werden.

Der aktive Sternkoppler 100 weist für jeden der vier Zweige einen eigenen Bus-Treiber (sogenannter Bus Driver, BD) 109, 110, 111, 112 auf. Die Bus-Treiber 109 - 112 entsprechen von ihrer Funktion her einer Sende-Empfangs-Einheit (sogenannter Transceiver). In den Bus-Treibern 109 - 112 wird die Differenz der über die beiden Leitungen der Zweige der Kommunikationsverbindung übertragenen und an den Anschlüssen 101, 102; 103, 104; 105, 106 oder 107, 108 anliegenden Signale gebildet und für jeden Zweig ein Differenzsignal generiert. Des weiteren wandeln die Bus-Treiber 109 - 112 ein über einen der Zweige eingehendes analoges Datensignal bzw. Differenzsignal in ein digitales Signal zur Weiterverarbeitung in dem Sternkoppler 100 um. Die Bitfolge des digitalen Signals wird dann von den Bus-Treibern 109 - 112 an eine zentrale Verarbeitungslogik 113 weitergeleitet, die ein Rechengerät, das bspw. als ein FPGA (Field Programmable Gate Array), ein Mikrocontroller, ein DSP (Digital Signal Processor), ein CPLD (Complex Programmable Logic Device) oder einfach als eine diskrete Logikschaltung ausgebildet ist, zur Verarbeitung des eingehenden digitalen Datensignals umfasst.

Wahlweise und deshalb gestrichelt dargestellt umfasst der bekannte Sternkoppler 100 einen Kommunikations-Controller (Communication Controller, CC) 114, der die über einen der Bus-Treiber 109 - 112 eingehenden und in der zentralen Verarbeitungslogik 113 vorverarbeiteten Daten weiter verarbeitet und/oder auswertet, um eine Überwachungs- und/oder Routerfunktionalität zu realisieren. Zur Realisierung der Routerfunktion müssen die eingehenden und vorverarbeiteten Daten inhaltlich analysiert werden, um zu ermitteln, für welchen der an den Sternkoppler 100 angeschlossenen Zweige bzw. für welchen der Teilnehmer die über einen der Kanäle eingegangenen Daten bestimmt sind. Diese Information kann in der Regel einem Kopf-Segment (Header) der eingehenden Datenpakete entnommen werden. Falls ein Kommunikations-Controller 114 in dem Sternkoppler 100 vorgesehen ist, sind an dem Sternkoppler 100 ein Empfangs-Anschluss (Receive, RxD) 115, ein Sendeanschluss (Transmit, TxD) 116 und ein Übertragungs-Auslöseanschluss (Transmit Enable, TxEN) 117 vorgesehen, welche an den Kommunikations-Controller 114 geführt sind.

Ebenfalls optional und deshalb gestrichelt dargestellt, umfasst der Sternkoppler 100 eine Überwachungseinheit in Form eines Bus-Guardian 118, welche den Zugriff des Kommunikations-Controllers 114 auf die Kommunikationsverbindung überwacht und/oder steuert. Der Bus-Guardian 118 ist über einen Bus-Guardian-Auslöseanschluss (Bus Guardian Enable BGE) 119 und ein Empfangs-Auslöseanschluss (Receive Enable, RxEN) 120 von außerhalb des Sternkopplers 100 ansteuerbar.

Schließlich umfasst der bekannte aktive Sternkoppler 100 auch eine Versorgungsspannungsquelle 121, an der über einen Anschluss (V_{CC}) 125 eine Betriebsspannung und über einen weiteren Anschluss 123 (GND) Masse anliegt. Zusätzlich kann ein Spannungsunterbrechungs-Anschluss (Inhibit, INH) 124 und ein Anschluss 122 (V_{Bat}) vorgesehen sein, an dem eine Bordnetzspannung eines Kraftfahrzeugs anliegt.

Beim Stand der Technik sind also die aktiven Sternkoppler mit Bus-Treibern 109 - 112 versehen, die funktional Sende-Empfangs-Einheiten entsprechen. Ein bekannter aktiver Sternkoppler ist somit nichts anderes als eine Verknüpfung mehrerer Transceiver zu einem Hub, wobei der Hub wesentlich mehr Funktionen beinhaltet, als für den Aufbau der Kommunikationsverbindung über den Sternkoppler eigentlich erforderlich wären. Die bekannten Sternkoppler 100 sind also sowohl vom Aufbau her, als auch funktional wesentlich aufwendiger und damit teurer als nötig.

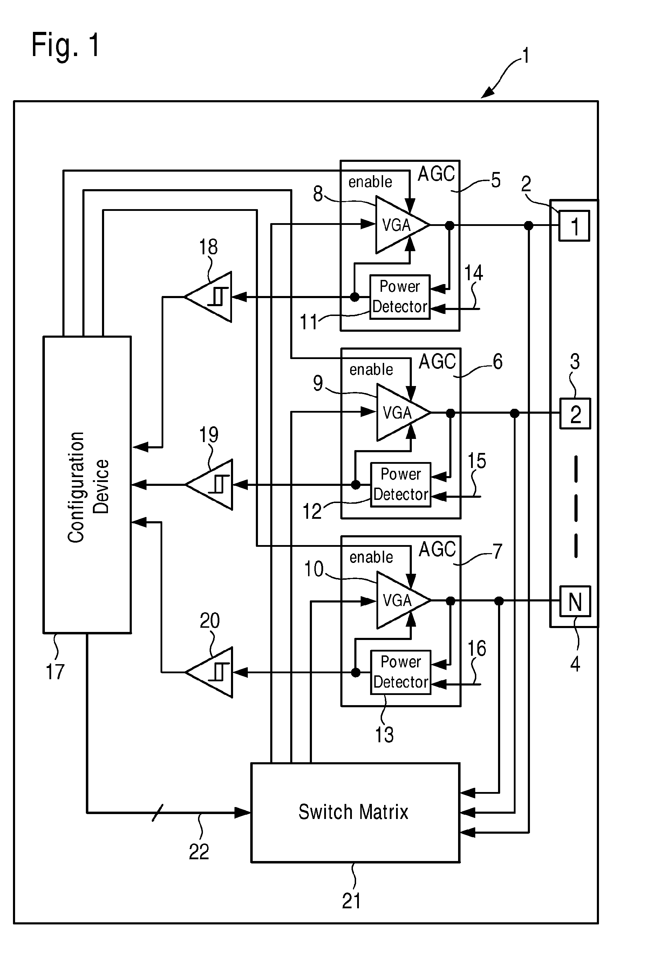

Erfindungsgemäß wird deshalb ein aktiver Sternkoppler vorgeschlagen (vergleiche Figur 1), welcher der FlexRay-Protokollspezifikation, insbesondere der Spezifikation v2.1, genügt, aber andererseits vom Aufbau her als auch funktional einfach und kostengünstig realisiert ist. Der erfindungsgemäße aktive Sternkoppler ist in Figur 1 in seiner Gesamtheit mit dem Bezugszeichen 1 bezeichnet. Der Sternkoppler 1 umfasst mehrere Anschlüsse 2, 3, 4, von denen in dem dargestellten Beispiel lediglich die Anschlüsse #1, #2 bis #N dargestellt sind. Selbstverständlich kann der Sternkoppler 1 auch lediglich zwei oder mehr als die dargestellten drei Anschlüsse aufweisen. Die Anschlüsse 2, 3, 4 können sowohl als Eingänge für eingehende Datensignale als auch als Ausgänge für abgehende Datensignale konfiguriert werden.

Des weiteren umfasst der erfindungsgemäße aktive Sternkoppler 1 für jeden der Anschlüsse 2, 3, 4 eigene analoge Signalverstärkermittel, vorzugsweise mit einem geregelten Verstärkungsfaktor. Die Signalverstärkermittel sind bspw. als eine Active Gain Control (AGC)-Schleife 5, 6, 7 ausgebildet. Die AGC-Schleifen 5, 6, 7 umfassen jeweils ein Verstärkungselement, vorzugsweise mit einem variablen Verstärkungsfaktor. Die Verstärkungselemente sind bspw. als Variable Gain Amplifier (VGA) bzw. in dem dargestellten Ausführungsbeispiel als Operationsverstärker 8, 9, 10 ausgebildet. Der Ausgang der Operationsverstärker 8, 9, 10 ist jeweils an einen der Anschlüsse 2, 3, 4 angeschlossen. Darüber hinaus umfassen die AGC-Schleifen 5, 6, 7 jeweils einen Leistungsmesser (Power Detector) 11, 12, 13, der die Leistung der am Ausgang der Operationsverstärker 8, 9, 10 bzw. an den Anschlüssen 2, 3, 4 anliegenden Signale misst und mit seinem Ausgangssignal den ihm zugeordneten Operationsverstärker 8, 9 oder 10 derart ansteuert, dass der variable Verstärkungsfaktor des Operationsverstärkers 8, 9 oder 10 auf einen bestimmten Wert eingestellt wird, bei dem die Ausgangsleistung des Operationsverstärkers 8, 9 oder 10 auf einen vorgebbaren Sollwert geregelt wird. Die Leistungsmesser 10, 12, 13 sind bspw. als ein Root-Mean-Square (RMS)-Detector ausgebildet. Erwünscht ist eine Quadrierung des eingehenden Signals, damit die Phasensprünge der DBPSK-Signale eliminiert werden. Ein RMS-Detektor ermittelt den Effektivwert bzw. die Leistung des Signals durch Berechnung der Wurzel, durch Mittelwertbildung und Quadrierung (Root-Mean-Square). Der Leistungssollwert pₛₒₗₗ kann über einen Eingang 14, 15, 16 des Leistungsmessers 11, 12, 13 vorgegeben werden.

An den Operationsverstärkern 8, 9, 10 der AGC-Schleifen 5, 6, 7 liegt außerdem ein Aktivierungssignal (enable) an, über das die Operationsverstärker 8, 9, 10 aktiviert bzw. deaktiviert werden können. Das Aktivierungssignal stammt von einer Konfigurationseinheit (configuration device) 17 des erfindungsgemäßen Sternkopplers 1. Der Ausgang der Leistungsmesser 11, 12, 13 wird des weiteren über eine Schmitt-Trigger-Schaltung 18, 19, 20 der Konfigurationseinheit 17 zugeführt. Die Schmitt-Trigger-Schaltungen 18, 19, 20 haben als Eingangssignal ein analoges, der Leistung des am Ausgang des Operationsverstärkers 8, 9 oder 10 anliegenden Signals entsprechendes Ausgangssignal des Leistungsmessers 11, 12 oder 13. Das Ausgangssignal der Schmitt-Trigger-Schaltungen 18, 19, 20 ist entweder 0 (Signalpegel < Schwellwert) oder 1 oder ein anderer Wert > 0 (Signalpegel > Schwellwert), je nach dem ob das Eingangssignal der Schmitt-Trigger-Schaltungen 18, 19, 20 unterhalb oder oberhalb eines vorgebbaren Schwellwerts liegt.

Schließlich umfasst der erfindungsgemäße aktive Sternkoppler 1 eine Schaltmatrix (Switch Matrix) 21, die von der Konfigurationseinheit 17 über eine Datenverbindung 22 angesteuert wird. Die Datenverbindung 22 kann als eine oder mehrere Leitungen ausgebildet sein, über welche Ansteuersignale für die Schaltmatrix 21 entweder seriell oder parallel übertragen werden. Das bedeutet also, dass die Datenverbindung 22 als ein Datenbus ausgebildet sein kann, über den die Ansteuersignale nach einem bestimmten Busprotokoll übertragen werden. Das Ansteuersignal kann ein analoges oder ein binäres Signal sein. Jeweils ein Ausgang der Schaltmatrix 21 ist an einen Eingang von einem der Operationsverstärker 8, 9, 10 angeschlossen. Jeweils ein Eingang der Schaltmatrix 21 ist an einen der Anschlüsse 2, 3, 4 angeschlossen. Über die Schaltmatrix 21 können beliebige, als Eingang konfigurierte Anschlüsse des Sternkopplers 1 mit beliebig anderen, als Ausgang konfigurierten Anschlüssen verbunden werden.

Nachfolgend wird der erfindungsgemäße aktive Sternkoppler 1 für den Einsatz in einem FlexRay-Kommunikationssystem beschrieben. Selbstverständlich kann er auch in beliebig anderen Kommunikationssystemen, beispielsweise in einer Powerline-Communications (PLC)-Umgebung eingesetzt werden. Der aktive Sternkoppler 1 für ein FlexRay-Kommunikationssystem kann verschiedene Betriebs-Modi einnehmen. Diese sind insbesondere:
- "Lauschen" auf eingehende Datensignale auf allen an den Anschlüssen 2, 3, 4 angeschlossenen Zweigen,
- Erkennen von Aktivität auf einem der Zweige (über einen aktiven Zweig eingehendes Datensignal),
- automatisches Konfigurieren des Sternkopplers 1 und Verteilen (und gegebenenfalls Verstärken) des über den aktiven Zweig eingehenden Datensignals auf einen oder mehrere der übrigen Zweige, und
- Erkennen von Busruhe (Datensignal liegt nicht mehr an).

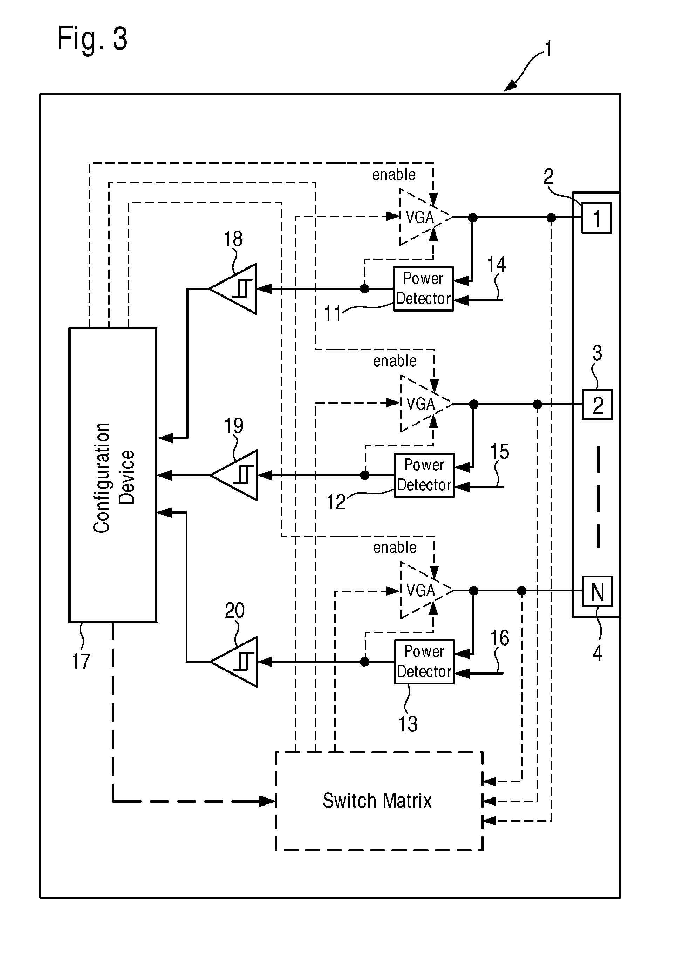

Von entscheidender Bedeutung bei dem erfindungsgemäßen aktiven Sternkoppler 1 sind die AGC-Schleifen 5, 6, 7, die eine schnelle Weiterleitung von Datensignalen mit minimalen Propagation Delays ermöglichen. Mittels der AGC-Schleifen 5, 6, 7, die das eingehende Datensignal auf die verschiedene Sternarme (Zweige) treiben, kann das abgehende Datensignal mit einem definierten Pegel ausgegeben werden, der derart gewählt ist, dass die EMV-Richtlinien möglichst gut eingehalten werden. In einem ersten Schritt muss der aktive Sternkoppler 1 nun durch die Konfigurationseinheit 7 so konfiguriert werden, dass er auf allen Zweigen nach einem eingehenden Datensignal "lauscht". Zu diesem Zweck deaktiviert die Konfigurationseinheit 17 alle Operationsverstärker 8, 9, 10 der AGC-Schleifen 5, 6, 7 über das Enable-Signal. Die entsprechende Konfiguration ist in Figur 3 dargestellt. Der in Figur 3 dargestellte Betriebsmodus des aktiven Sternkopplers 1 wird auch als Idle-Mode bezeichnet. Alle Anschlüsse 2, 3, 4 sind als Eingänge konfiguriert und "lauschen" nach eingehenden Datensignalen. Ein an einem der Anschlüsse 2, 3, 4 der Zweige (an dem aktiven Anschluss) eingehendes Datensignal wird über den entsprechenden Leistungsmesser 11, 12 oder 13 und die dazu gehörige Schmitt-Trigger-Schaltung 18, 19 oder 20 an die Konfigurationseinheit 17 weitergeleitet. Übersteigt das eingehende Datensignal den in der Schmitt-Trigger-Schaltung 18, 19 oder 20 eingestellten Schwellwert, liegt am Ausgang der Schmitt-Trigger-Schaltung 18, 19 oder 20 und somit auch an dem entsprechenden Eingang der Konfigurationseinheit 17 ein Signalwert > 0, vorzugsweise ein Signalwert = 1, an. Dadurch erkennt die Konfigurationseinheit 17, dass an dem aktiven Anschluss, beispielsweise an dem Anschluss 2 mit der #1, ein eingehendes Datensignal anliegt.

Damit der fehlerfreie Betrieb des Sternkopplers 1 im Idle-Mode gewährleistet ist, müssen zunächst die Operationsverstärker 8, 9, 10 deaktiviert werden, so dass diese eine sehr hohe Ausgangsimpedanz besitzen und das eingehende Datensignal nicht verfälschen. Im Normalbetrieb haben die Operationsverstärker 8, 9, 10 nämlich eine relativ niedrige Ausgangsimpedanz, die das eingehende Datensignal kurzschließen würde. Somit wird das eingehende Datensignal über den Rückkoppelzweig der AGC-Schleifen 5, 6, 7 (über den Leistungsmesser 11, 12, 13) geführt. Idealerweise ist in dem Rückkoppelzweig noch ein Bandpass-Filter (in den Figuren nicht dargestellt) vorgesehen, damit unerwünschte Nebenfrequenzen herausgefiltert werden und das Ergebnis nicht verfälschen können.

Die Leistungsmesser 11, 12, 13 können - wie gesagt - als sogenannte True-RMS (Root-Mean-Square)-Detektoren realisiert sein. Die Leistungsmesser 11, 12, 13 bilden in Kombination mit den nachfolgenden Schmitt-Trigger-Schaltungen 18, 19, 20 einen sogenannten Activity-Detektor, mittels dem ein eingehendes Datensignal (also eine Aktivität) auf einem der angeschlossenen Zweige, erkannt werden kann. Der RMS-Detektor 11 des aktiven Zweiges, auf dem ein eingehendes Datensignal anliegt, führt eine Quadrierung des Signals durch, was speziell bei einem DBPSK-(Differential Binary Phase Shift Keying)-Signal zu einer Elimination von Phasensprüngen führt. Am Ausgang des RMS-Detektors 11 steigt die Spannung in Abhängigkeit von der Leistung (dem Pegel) des eingehenden Datensignals an, bis die frei wählbare Schwelle der Schmitt-Trigger-Schaltung 18 überschritten wird und die Schmitt-Trigger-Schaltung 18 auslöst. Der Konfigurationseinheit 17 wird durch das Auslösen der Schmitt-Trigger-Schaltung 18 mitgeteilt, dass ein eingehendes Datensignal an dem aktiven Anschluss 2 mit der #1 erkannt wurde, worauf die Konfigurationseinheit 17 die übrigen Anschlüsse 3, 4 mit der #2 bis #N als Ausgänge konfiguriert, indem die Operationsverstärker 9, 10 mittels des Enable-Signals aktiviert werden.

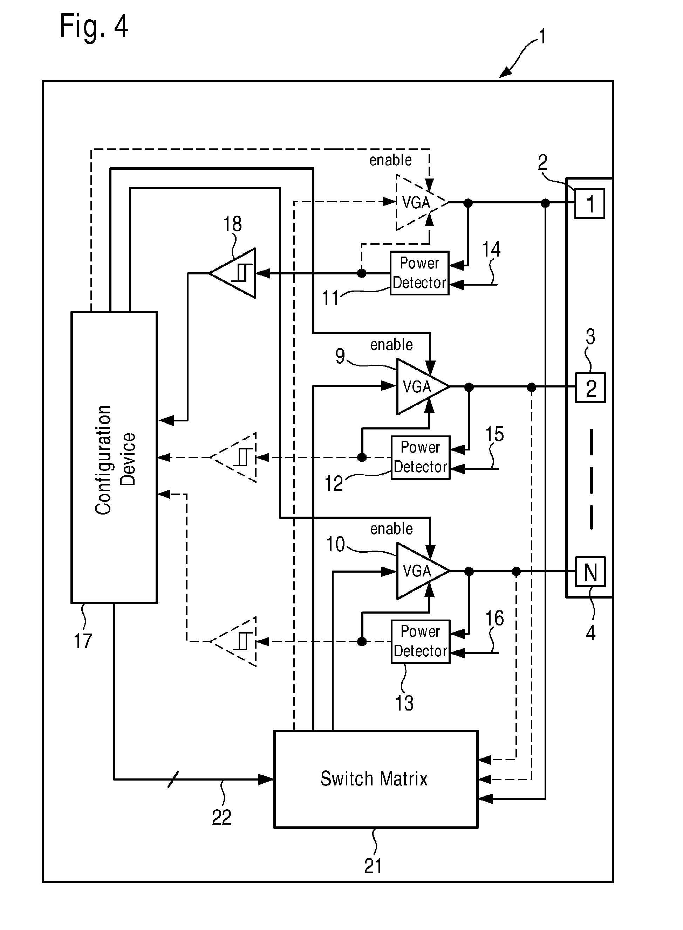

Figur 4 zeigt hierzu ein Beispiel, bei dem an dem aktiven Anschluss 2 mit der #1 ein eingehendes Datensignal detektiert wurde und nun auf die Anschlüsse 3, 4 mit der #2 bis #N verstärkt weitergeleitet wird. Die Konfigurationseinheit 17 belässt zunächst den Operationsverstärker 8 an Kanal 1 deaktiv, damit das eingehende Datensignal, wie schon zuvor erwähnt, nicht verfälscht wird. Indes werden jedoch die übrigen Verstärker 9, 10 über das Enable-Signal aktiviert. Damit sind die AGC-Schleifen 6, 7 nun wieder geschlossen und das Datensignal kann mit einem definierten Pegel auf die an den Anschlüssen 3, 4 angeschlossenen Teilnehmer verteilt werden. Mittels der Schaltmatrix 21 muss dazu das eingehende Datensignal von Kanal 1 auf die Eingänge der AGC-Schleifen 6, 7 der Kanäle 2 bis N geschaltet werden. Dies kann zum einen mittels eines sogenannten Cross-Point-Switch geschehen, oder aber mit einfachen digitalen Schaltern, die eine besonders kurze Schaltzeit von wenigen Nanosekunden besitzen. Die Ansteuerung der Schaltmatrix 21 durch die Konfigurationseinheit 17 über die Datenverbindung 22 geschieht vorzugsweise mittels eines binären Ansteuersignals, wobei jeweils ein Bit des Ansteuersignals eine Verbindung zwischen einem ersten und einem zweiten Anschluss 2, 3, 4 repräsentiert. Bspw. könnte ein erstes Bit eine Verbindung zwischen den Anschlüssen #1 und #2, ein zweites Bit eine Verbindung zwischen den Anschlüssen #1 und #N, und ein drittes Bit eine Verbindung zwischen den Anschlüssen #2 und #N repräsentieren. Ein auf '1' gesetztes Bit könnte dabei für eine geschlossene Verbindung und ein auf '0' gesetztes Bit für eine unterbrochene Verbindung stehen. Der Pegel des verstärkten Signals an den Anschlüssen 3, 4 mit den #2 bis #N wird über die Eingänge 15, 16 der Leistungsmesser 12, 13 vorgegeben.

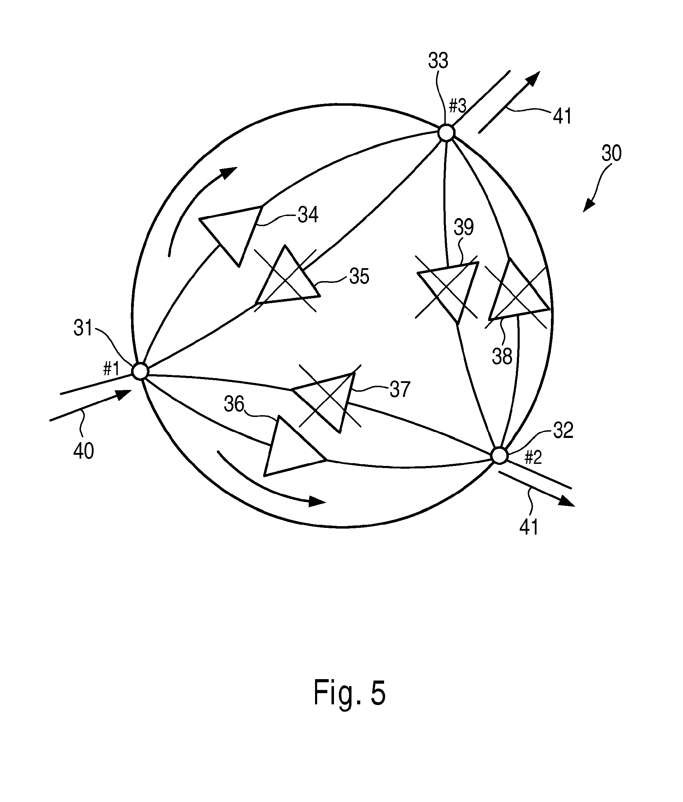

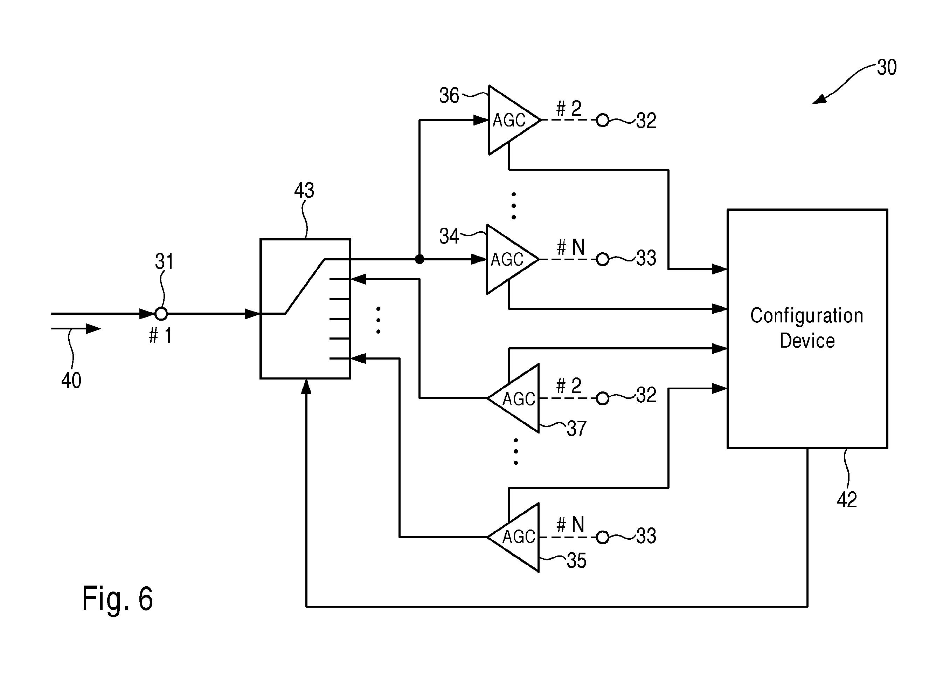

Neben der beschriebenen platzsparenden Ausführungsform der Erfindung gibt es weitere Möglichkeiten zur Realisierung der Erfindung. Nachfolgend wird anhand der Figuren 5 und 6 ein weiteres Ausführungsbeispiel beschrieben, bei dem durch eine hohe Redundanz ein erhöhtes Maß an Sicherheit bezüglich eines Komplettausfalls des aktiven Sternkopplers gegeben ist. In Figur 5 ist der erfindungsgemäße aktive Sternkoppler gemäß einer weiteren Ausführungsform in seiner Gesamtheit mit dem Bezugszeichen 30 bezeichnet. Der dargestellte Sternkoppler 30 umfasst drei Anschlüsse 31, 32, 33, die sowohl als Eingänge für eingehende Datensignale als auch als Ausgänge für abgehende Datensignale konfiguriert werden können. Der Sternkoppler 30 umfasst zwischen jedem der Anschlüsse 31, 32, 33 zwei entgegengesetzt geschaltete AGC-Schleifen 34, 35; 36, 37; und 38, 39. Die AGC-Schleifen 34 bis 39 sind in Figur 5 nur symbolisch durch ihre Verstärkerelemente (Variable Gain Amplifiers, Operationsverstärker) dargestellt. Durch die AGC-Schleife 34 können beispielsweise Datensignale von dem Anschluss 31 (#1) zu dem Anschluss 33 (#N) verstärkt werden. Durch die AGC-Schleife 35 können entgegengerichtete Datensignale von dem Anschluss 33 (#N) zu dem Anschluss 31 (#1) verstärkt werden. In entsprechender Weise können durch die übrigen AGC-Schleifen 36 bis 39 Datensignale in die eine oder in die andere Richtung verstärkt werden. Durch Aktivieren bzw. Deaktivieren der AGC-Schleifen 34 bis 39 bzw. der entsprechenden Verstärkerelemente (Operationsverstärker) können die Verbindungen zwischen den Anschlüssen 31, 32, 33 gezielt aktiviert oder gesperrt werden. So kann durch gezieltes Ansteuern der AGC-Schleifen 34 bis 39 ein an dem Anschluss 31 (#1) eingehendes Datensignal 40 auf die beiden anderen Anschlüsse 32, 33 (#2, #N) verteilt und verstärkt werden. Das verteilte und verstärkte Ausgangssignal ist mit dem Bezugszeichen 41 bezeichnet. Die dabei deaktivierten AGC-Schleifen 35, 37, 38, 39 sind in Figur 5 symbolisch durchgekreuzt.

Der erfindungsgemäße aktive Sternkoppler 30 gemäß der zweiten Ausführungsform umfasst außerdem eine Konfigurationseinheit, die in Figur 6 mit dem Bezugszeichen 42 bezeichnet ist. In Figur 5 ist die Konfigurationseinheit 42 der besseren Übersichtlichkeit wegen nicht dargestellt. Außerdem umfasst der aktive Sternkoppler 30 ein analoges oder digitales Schaltelement 43, um über einen aktiven Anschluss eingehende Datensignale auf einen oder mehrere andere Anschlüsse schalten zu können. Zwischen den Leistungsmessern (nicht dargestellt) der AGC-Schleifen 34 bis 39 und der Konfigurationseinheit 42 können - wie bei dem ersten Ausführungsbeispiel - Schmitt-Trigger-Schaltungen (nicht dargestellt) angeordnet sein. Der Vorteil des Sternkopplers 30 gemäß dem zweiten Ausführungsbeispiel liegt darin, dass statt einer relativen komplexen und teuren Schaltmatrix ein einfaches Schaltelement 43 zum Einsatz kommen kann. Außerdem liegt ein Vorteil des Sternkopplers 30 in der redundanten Ausgestaltung der AGC-Schleifen 34 bis 39 zwischen den verschiedenen Anschlüssen 31, 32, 33 des Sternkopplers 30. Bei einem Ausfall einer der AGC-Schleifen 34 bis 39 wirkt sich der Fehler nur auf einen der Anschlüsse 31, 32, 33 des Sternkopplers 30 unidirektional aus, die restlichen Anschlüsse und der restliche Teil des aktiven Sternkopplers 30 würde fehlerfrei weiterarbeiten.

Sämtliche Anschlüsse 31, 32, 33 des aktiven Sternkopplers 30 sind untereinander bidirektional durch AGC-Schleifen 34 bis 39 verbunden. Somit kommt man für den Aufbau des aktiven Sternkopplers 30 insgesamt auf n (n-1) AGC-Schleifen 34 bis 39, wobei n die Anzahl der Anschlüsse 31, 32, 33 darstellt. In dem dargestellten Beispiel kommt man also auf 3 (3-1) = 6 AGC-Schleifen 34 bis 39. Demgegenüber genügen bei der ersten Ausführungsform gemäß den Figuren 1, 3 und 4 n AGC-Schleifen 5, 6, 7, wobei auch hier n für die Anzahl der Anschlüsse 2, 3, 4 steht. Selbstverständlich besteht bei der Ausführungsform gemäß der Figuren 5 und 6 die Möglichkeit, bei der Detektion von eingehenden Datensignalen weitere Rückkoppelzweige bzw. Leistungsdetektoren zu nutzen.

## Patentansprüche

1. Aktiver Sternkoppler (1; 30) für den Einsatz in einem Kommunikationssystem mit Sterntopologie, wobei der Sternkoppler (1; 30) mindestens einen Eingang (2; 31) für ein eingehendes analoges Datensignal (40) und mindestens einen Ausgang (3, 4; 32, 33) für ein abgehendes analoges Datensignal (41) und zwischen dem mindestens einen Eingang (2; 31) und dem mindestens einen Ausgang (3, 4; 32, 33) angeordnete Mittel (5, 6, 7; 34, ..., 39) zum Verstärken des eingehenden Datensignals (40) aufweist, **dadurch gekennzeichnet, dass** die Verstärkermittel (5, 6, 7; 34, ..., 39) als analoge Signalverstärkermittel zur unmittelbaren Verstärkung eines in den Sternkoppler (1; 30) eingehenden analogen Datensignals (40) ausgebildet sind.

2. Sternkoppler (1; 30) nach Anspruch 1, **dadurch gekennzeichnet, dass** jedem Ausgang (3, 4) des Sternkopplers (1; 30) gesonderte analoge Signalverstärkermittel vorgeschaltet sind.

3. Sternkoppler (1; 30) nach Anspruch 1 oder 2, **dadurch gekennzeichnet, dass** der Sternkoppler (1; 30) eine Konfigurationseinheit (17; 42) aufweist, welche den Sternkoppler (1; 30) in Abhängigkeit von einem gewünschten Betriebsmodus des Sternkopplers (1; 30) konfiguriert.

4. Sternkoppler (1; 30) nach einem der Ansprüche 1 bis 3, **dadurch gekennzeichnet, dass** der Sternkoppler (1; 30) eine Konfigurationseinheit (17; 42) aufweist, welche die analogen Signalverstärkermittel (5, 6, 7; 34, ..., 39) aktiviert bzw. deaktiviert.

5. Sternkoppler (1) nach einem der Ansprüche 1 bis 4, **dadurch gekennzeichnet, dass** der Sternkoppler (1) eine Schaltmatrix (21) aufweist, über die alle Eingänge (2) des Sternkopplers (1) mit allen Ausgängen (3, 4) des Sternkopplers (1) verbunden sind.

6. Sternkoppler (1) nach Anspruch 5, **dadurch gekennzeichnet, dass** der Sternkoppler (1) eine Konfigurationseinheit (17) aufweist, welche die Schaltmatrix (21) ansteuert und mindestens einen der Eingänge (2) mit mindestens einem der Ausgänge (3, 4) verknüpft.

7. Sternkoppler (1; 30) nach einem der Ansprüche 1 bis 6, **dadurch gekennzeichnet, dass** die analogen Signalverstärkermittel (5, 6, 7; 34, ..., 39) als Automatic Gain Control (AGC)-Schleifen ausgebildet sind.

8. Sternkoppler (1, 30) nach Anspruch 7, **dadurch gekennzeichnet, dass** die AGC-Schleifen (5, 6, 7; 34, ..., 39) jeweils einen Operationsverstärker (8, 9, 10) dessen Ausgangsanschluss an mindestens einem der Eingänge (2; 31) oder mindestens einem der Ausgänge (3, 4; 32, 33) des Sternkopplers (1; 30) angeschlossen ist, und einen Leistungsmesser (11, 12, 13) aufweisen, der die am Ausgangsanschluss des Operationsverstärkers (8, 9, 10) anliegende Leistung misst und dem Operationsverstärker (8, 9, 10) ein der gemessenen Leistung entsprechendes Signal zur Verfügung stellt.

9. Sternkoppler (1; 30) nach Anspruch 8, **dadurch gekennzeichnet, dass** die Leistungsmesser (11, 12, 13) der AGC-Schleifen (5, 6, 7; 34, ..., 39) die gemessene Leistung einer Konfigurationseinheit (17; 42) des Sternkopplers (1; 30) zur Verfügung stellen.

10. Sternkoppler (1; 30) nach Anspruch 9, **dadurch gekennzeichnet, dass** zwischen den Leistungsmessern (11, 12, 13) der AGC-Schleifen (5, 6, 7; 34, ..., 39) und der Konfigurationseinheit (17; 42) des Sternkopplers (1; 30) jeweils eine Schmitt-Trigger-Schaltung (18, 19, 20) angeordnet ist.

11. Sternkoppler (1; 30) nach einem der Ansprüche 8 bis 10, **dadurch gekennzeichnet, dass** die Operationsverstärker (8, 9, 10) der AGC-Schleifen (5, 6, 7; 34, ..., 39) Aktivierungsanschlüsse zum Aktivieren und Deaktivieren der Operationsverstärker (8, 9, 10) aufweisen, und der Sternkoppler (1; 30) eine Konfigurationseinheit (17; 42) aufweist, welche die Operationsverstärker (8, 9, 10) der AGC-Schleifen (5, 6, 7; 34, ..., 39) durch Anlegen eines Aktivierungs-/ Deaktivierungssignals an die Operationsverstärker (8, 9, 10) aktiviert bzw. deaktiviert.

12. Sternkoppler (1; 30) nach einem der Ansprüche 1 bis 11, **dadurch gekennzeichnet, dass** der Sternkoppler (1; 30) mehrere Anschlüsse (2, 3, 4; 31, 32, 33) aufweist, die jeweils sowohl als Eingang des Sternkopplers (1, 30) als auch als Ausgang konfigurierbar sind.

13. Sternkoppler (1; 30) nach einem der Ansprüche 3 bis 12, **dadurch gekennzeichnet, dass** in einem Idle-Betriebsmodus des Sternkopplers (1; 30) alle analogen Signalverstärkermittel (5, 6, 7; 34, ..., 39) deaktiviert sind.

14. Sternkoppler (1; 30) nach Anspruch 12 oder 13, **dadurch gekennzeichnet, dass** im Idle-Betriebsmodus des Sternkopplers (1; 30) Leistungsmesser (11, 12, 13) der analogen Signalverstärkermittel (5, 6, 7; 34, ..., 39) die an den Anschlüssen (2, 3, 4; 31, 32, 33) des Sternkopplers (1; 30) anliegenden Signale einer Konfigurationseinheit (17; 42) des Sternkopplers (1; 30) zur Verfügung stellen.

15. Sternkoppler (1) nach einem der Ansprüche 12 bis 14, **dadurch gekennzeichnet, dass** die Konfigurationseinheit (17) des Sternkopplers (1) ein über einen der Anschlüsse (2) eingehendes Datensignal detektiert, daraufhin alle Anschlüsse (3, 4) des Sternkopplers (1) außer dem Anschluss (2), an dem das Datensignal eingeht, als Ausgänge (3, 4) konfiguriert, indem es die Operationsverstärker (9, 10) der AGC-Schleifen (6, 7) der Ausgänge (3, 4) aktiviert, und die Schaltmatrix (21) derart ansteuert, dass der Anschluss (2), an dem das Datensignal eingeht, mit den Ausgängen (3, 4) verknüpft ist.

16. Sternkoppler (30) nach einem der Ansprüche 1 bis 14, **dadurch gekennzeichnet, dass** zwischen allen Anschlüssen (31, 32, 33) des Sternkopplers (30) jeweils zwei in entgegengesetzter Richtung geschaltete AGC-Schleifen (34, ..., 39) angeordnet sind.
